Europäisches Patentamt

European Patent Office

Office européen des brevets

(11) Veröffentlichungsnummer: **0 212 452 B1**

# EUROPÄISCHE PATENTSCHRIFT

(45) Veröffentlichungstag der Patentschrift: **02.01.92**

(51) Int. Cl.5: **G01R 33/035**

(21) Anmeldenummer: **86110875.1**

(22) Anmeldetag: **06.08.86**

Die Akte enthält technische Angaben, die nach dem Eingang der Anmeldung eingereicht wurden und die nicht in dieser Patentschrift enthalten sind.

(54) **Messvorrichtung mit einem SOUID-Magnetometer.**

(30) Priorität: **20.08.85 DE 3529815**

(43) Veröffentlichungstag der Anmeldung:
**04.03.87 Patentblatt 87/10**

(45) Bekanntmachung des Hinweises auf die Patenterteilung:
**02.01.92 Patentblatt 92/01**

(84) Benannte Vertragsstaaten:
**DE FR IT NL**

(56) Entgegenhaltungen:
**EP-A- 0 090 220**
**WO-A-81/03710**
**US-A- 4 489 274**

**PATENT ABSTRACTS OF JAPAN, Band 8, Nr. 14 (P-249)[1451], 21. Januar 1984; & JP-A-58 174 866**

**IEEE TRANSACTIONS ON MAGNETICS, Band MAG-17, Nr. 1, Januar 1981, Seiten 400-403, IEEE, New York, US; J.M. JAYCOX et al.: "Planar coupling scheme for ultra low noise DC squids"**

**SOUID-Superconducting Ouantum Interference Devices and their Applications(Proc.Int.Conf on Supercond.Ouantum Devices,Berlin 1976) 1977,S 439-484**

**IEEE Transactions on Magnetics,Vol.MAG-19,No.3,Mai 1983,S. 461-464;**

**IEEE Transactions on Magnetics,Vol. MAG-19,No.3,Mai 1983,S. 303-307**

(73) Patentinhaber: **SIEMENS AKTIENGESELL-SCHAFT**
**Wittelsbacherplatz 2**
**W-8000 München 2(DE)**

(72) Erfinder: **Hoenig, Eckhardt, Dr.**
**Palmstrasse 1a**
**W-8520 Erlangen(DE)**

## Beschreibung

Die Erfindung bezieht sich auf eine Vorrichtung zur Messung von schwachen magnetischen Feldern extrem geringer Frequenz gemäß dem gattungsbildenden ersten Teil des Anspruchs 1. Eine derartige Meßvorrichtung geht aus der US-A-4 489 274 hervor.

Mit SQUIDs (supraleitenden Quanteninterferometern) lassen sich Magnetometer hoher Magnetfeldempfindlichkeit, z.B. in der Größenordung von $10^{-14}$ Tesla $\cdot$ (Hertz)$^{-1/2}$ aufbauen. Ein entsprechendes Magnetometer enthält im allgemeinen neben einem SQUID-Sensor noch einen Flußtransformator, mit dem das zu detektierende Magnetfeld induktiv in den SQUID-Sensor eingekoppelt werden kann.

Bei derartigen Magnetometern ist die äußerste Grenze für ihre Empfindlichkeit durch das sogenannte 1/f-Rauschen festgelegt, d.h. umgekehrt proportional zur Frequenz (vgl. z.B. "Journal of Low Temperature Physics", Vol. 51, Nos. 1/2, 1983, Seiten 207 bis 224).

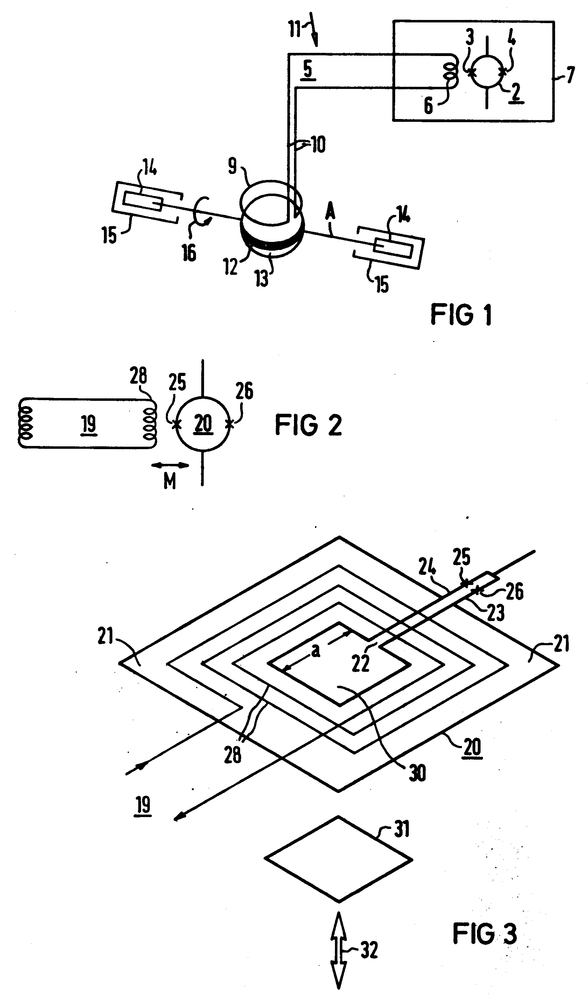

Aus der Veröffentlichung "SQUID-Superconducting Quantum Interference Devices and their Applications" (Proc. Int. Conf. on Supercond. Quantum Devices, Berlin 1976), 1977, Seiten 439 bis 484 ist eine Vorrichtung zur Unterwasser-Kommunikation zu entnehmen, mit der auch magnetische Felder mit extrem geringen Frequenzen von 30 bis 3000 Hz zu detektieren sind. Diese Vorrichtung weist unter anderem ein RF-SQUID als Sensor auf, der zusammen mit einem supraleitenden Flußtransformator in einem Kryostaten angeordnet ist (vgl. Seite 449, Figur 3). Dieser Flußtransformator umfaßt eine als Antenne dienende Feldspule, auch Detektionsschleife genannt, die mit einer Koppelspule zur Einkopplung des Meßsignals in das SQUID verbunden ist. Diese supraleitenden Teile der Vorrichtung können insbesondere als Dünnfilmstruktur ausgebildet sein. Dem aus Flußtransformator und SQUID-Sensor gebildeten supraleitenden Teil der Vorrichtung ist eine rauscharme Elektronik nachgeschaltet.

Zur weiteren Herabsetzung des Rauschens ist darüber hinaus bekannt, für derartige Meßvorrichtungen Gleichstrom-SQUIDs zu verwenden (vgl. z.B. "Applied Physics Letters", Vol. 40, Nr. 8, 15.4.1982, Seiten 736 bis 738).

Will man jedoch quasi statische Magnetfelder mit Frequenzen von z.B. 0,01 Hz bei Meßzeiten im Sekundenbereich messen, so sind wegen des erwähnten, unterhalb von etwa 1 Hz einsetzenden 1/f-Rauschens eines SQUID-Sensors zusätzliche Maßnahmen zu ergreifen, die eine Modulation der in das SQUID einzukoppelnden Meßsignale mit einer Modulationsfrequenz, die in einem für einen rauscharmen Betrieb des SQUIDs charakteristischen Frequenzbereich liegt, ermöglichen. Entsprechende Maßnahmen sind bei der in der eingangs genannten US-A-4 489 274 beschriebenen Meßvorrichtung vorgesehen. Diese Meßvorrichtung enthält ein supraleitendes Magnetometer- und Gradiometer-Array mit mehreren Detektionsschleifen zum Empfang schwacher magnetischer Felder. Die Detektionsschleifen bilden zusammen mit Koppelspulen supraleitende Flußtransformatoren. Über die Koppelspulen werden induktiv die empfangenen Meßsignale in Schleifen von jeweils zugeordneten RF-SQUIDs eingekoppelt. Der das Magnetometer- und Gradiometer-Array sowie die SQUIDs aufnehmende Kryostat und ein Teil einer nachgeordneten signalverarbeitenden Elektronik können mit einer vorbestimmten geringen Frequenz um eine Achse rotieren, deren Ausrichtung zusätzlich noch in einer Ebene zu verdrehen ist. Mit der Rotation ist eine Modulation des empfangenen Signals verbunden. Der apparative Aufwand zur Rotation des Kryostaten sowie Zur Signalübertragung von den rotierenden auf feststehende Teile der bekannten Meßvorrichtung ist jedoch verhältnismäßig hoch.

Ferner ist es aus der WO-A-81 03710 bekannt, bei Gleichstrom-SQUIDs eine elektronische Modulation des Arbeitspunktes (Bias-Modulation) vorzusehen.

Darüber hinaus ist der JP-A-58 174866 eine Vorrichtung zur Messung eines magnetischen Gleichfeldes zu entnehmen, bei der das Flußübertragungsmaß (Flußtransfer) in einem einem RF-SQUID vorgeordneten Flußtransformator mit einer vorbestimmten niedrigen Modulationsfrequenz zu beeinflussen ist. Hierzu ist in dem mit einer Detektionsschleife und einer Koppelspule gebildeten Flußtransformator parallel zu der Koppelspule eine Zusatzspule geschaltet. Die Induktivität dieser Zusatzspule kann mittels eines mit der vorbestimmten Modulationsfrequenz periodisch auf diese Spule einwirkenden Probeköpers variiert werden. Für eine wirksame Modulation des Flußtransfers muß aber wegen der Parallelschaltung der Zusatzspule zu der Koppelspule eine unerwünschte Dämpfung des Meßsignals in Kauf genommen werden. Außerdem geht die Modulation nicht linear in den Flußtransfer ein, so daß eine entsprechend aufwendige elektronische Aufbereitung des Meßsignals erforderlich ist.

Aufgabe der vorliegenden Erfindung ist es, die Meßvorrichtung mit den aus dem ersten Teil des Anspruches 1 entnehmbaren Merkmalen dahingehend auszugestalten, daß mit ihr quasi statische Magnetfelder mit Frequenzen weit unter etwa 1 Hz, insbesondere unter 0,1 Hz, mit der für SQUID-Magnetometer typischen hohen Magnetfeldempfindlichkeit so zu detektieren sind, daß der konstruktive Aufwand zur Modulation der Meßsignale und zu deren elektronischer Aufbereitung verringert werden.

Diese Aufgabe wird erfindungsgemäß mit den im kennzeichnenden Teil des Anspruches 1 aufgeführten Maßnahmen gelöst.

Mit dem Flußtransformator bzw. mit Teilen von ihm wird also erfindungsgemäß eine auch als Effektmodulation bezeichnete Modulation des mit der Detektionsspule oder -schleife des Flußtransformators empfangenen Signals und damit des Flußtransfers vorgenommen. Die entsprechenden Maßnahmen zur Modulation, die sich dabei auf einen Teil des Flußtransformators, wie z.B. auf dessen Detektionsschleife oder auf dessen Koppelspule jeweils einzeln oder gegebenenfalls auch auf die Anordnung aus Flußtransformator und SQUID gemeinsam erstrecken können, sind verhältnismäßig einfach durchzuführen.

Vorteilhafte Ausgestaltungen der Meßvorrichtung nach der Erfindung gehen aus den abhängigen Ansprüchen hervor.

Zur weiteren Erläuterung der Erfindung und deren mit den Unteransprüchen gekennzeichneten Weiterbildungen wird auf die Zeichnung Bezug genommen, in deren Figuren zwei grundsätzliche Wege zur Lösung der der Erfindung zugrundeliegenden Aufgabe angedeutet sind. Dabei ist in Figur 1 schematisch eine Modulationseinrichtung der erfindungsgemäßen Meßvorrichtung veranschaulicht. Die Figuren 2 bis 6 zeigen schematisch weitere Ausbildungsmöglichkeiten solcher Modulationseinrichtungen. In den Figuren sind übereinstimmende Teile mit den gleichen Bezugszeichen versehen.

Lösungsweg I

Gemäß der Skizze nach Figur 1 enthält die erfindungsgemäße Meßvorrichtung ein Gleichstrom-SQUID 2 mit zwei Josephson-Tunnelelementen 3 und 4. An das SQUID ist induktiv ein supraleitender Flußtransformator 5 über eine Koppelspule 6 angekoppelt, wobei das SQUID und die beispielsweise mit ihm integrierte Koppelspule von einer supraleitenden Abschirmung 7 umschlossen sind. Der Flußtransformator 5 enthält neben der Koppelspule zum Empfang des zu messenden Magnetfeldes eine ebene Detektions- oder Sensorschleife 9, die über supraleitende Verbindungsleiter 10 an die Koppelspule 6 angeschlossen ist. Statt der in der Figur dargestellten ebenen Sensorschleife mit einer einzigen Windung kann man auch eine Helmholtzspule verwenden. Ströme in dem Flußtransformator vor Beginn der eigentlichen Messung werden in bekannter Weise auf null gebracht. Wie in der Figur durch eine gepfeilte Linie 11 angedeutet sein soll, kann ein derartiges Nullen der Transformatorströme z.B. mittels über Lichtleiter zuzuführender Wärmeimpulse vorgenommen werden.

Der Flußtransformator läßt sich ferner auch durch eine besondere Gegenkopplung stromlos machen.

Das mit der Detektionsschleife 9 zu empfangende Magnetfeld wird im Bereich dieser Schleife durch einen bewegten Abschirmring 12 mit einer solchen Frequenz moduliert, daß das Meßsignal in einen Frequenzbereich des SQUIDs 2 verlagert wird, in dem ein rauscharmer Betrieb zu gewährleisten ist. Entsprechende Modulationsfrequenzen liegen im allgemeinen über 1 Hz, vorzugsweise über 100 Hz, z.B. über 1 kHz.

Zur Modulation kann vorteilhaft der Abschirmring 12 als ringförmiger Metallfilm auf einem kugelförmigen Träger 13 angeordnet sein. Dieser Metallfilm kann insbesondere aus einem supraleitenden Material bestehen, dessen Übergangstemperatur möglichst dicht über der Temperatur des erforderlichen kryogenen Mediums liegt, mit dem er zu kühlen ist. Dann läßt sich nämlich auch dieser Abschirmring 12 beispielsweise auf optischem Wege leicht in den normalleitenden Zustand überführen. Der den Metallfilm aufnehmende Träger 13 ist auf einer Achse A befestigt, deren gegenüberliegenden freien Enden jeweils in einem supraleitenden Magnetlager 14 mit supraleitender Abschirmung 15 gehalten sind. Die Felder für diese Magnetlager werden vorteilhaft erst bei Vorliegen des supraleitenden Zustandes der Lagerabschirmung mit kurzgeschlossenen Supraleitungsspulen aufgebaut, die bei Betrieb keine Zuleitungsströme erfordern. Wie in der Figur durch eine gepfeilte Linie 16 angedeutet ist, soll sich der Träger 13 als Teil eines nicht weiter ausgeführten Modulationsrotors, der unter Umständen Teil eines Stabilisierungs-Kreiselsystems sein kann, um die zum Abschirmring 12 transversal und zur Ebene der Detektionsschleife 9 parallel liegende Achse A mit vorbestimmter Drehzahl drehen. Bei einer solchen Drehung moduliert der Abschirmring 12 den Fluß in der Detektionsschleife 9 mit entsprechender Modulationsfrequenz. Ein den Rotorwinkel kennzeichnendes Signal für die Demodulation des Meßsignals kann dabei induktiv einem Rotorlager entnommen werden.

Das so aufgebaute Magnetometer mit dem SQUID 2 wird vorteilhaft in einem Kühlmittelbehälter mit superfluidem Helim angeordnet, um so die Dämpfung des Rotors klein zu halten. Eine Entdämpfung der Rotordrehung kann z.B. durch magnetische Drehfelder, die auf einem supraleitenden Kurzschlußläufer in der supraleitend abgeschirmten Rotorlagerung wirken, erreicht werden.

Gemäß dem in der Figur dargestellten Ausführungsbeispiel wurde davon ausgegangen, daß das mit der einzigen, in einer Ebene angeordneten Detektionsschleife 9 empfangene Feld mit dem Abschirmring 12 moduliert wird. Ebensogut kann jedoch dieser Abschirmring auch auf zwei entsprechende, orthogonal angeordnete Detektionsschleifen einwirken.

Außerdem ist auch die Realisierung einer kleinen, nur das eigentliche Detektionssystem tragenden stabilisierten Plattform im superfluiden Helium denkbar, wobei wiederum supraleitende Magnetlager und supraleitende Abschirmungen zu verwenden sind.

Zur Kompensation eines konstanten Hintergrundfeldes kann eine starr mit dem Meßsystem verbundene Spulenanordnung benutzt werden. Um größtmögliche Stabilität des Kompensationsfeldes zu erreichen, kann dieses vorteilhaft mittels supraleitender Spulen erzeugt werden, die über supraleitende Schalter kurzgeschlossen sind. Eine mechanische Stabilisierung des Meßsystems relativ zum konstanten Hintergrundfeld ist dabei vorzusehen.

Auch Störfelder der Umgebung, sofern sie auf bewegte magnetische Objekte der Umgebung zurückzuführen sind, lassen sich durch starr mit den bewegten Objekten verbundene Kompensationsspulen reduzieren. Daneben ist eine wesentliche Unterdrückung von Störfeldern der unmittelbaren Umgebung des Meßfeldes durch Verwendung einer entfernten Referenz in Gestalt eines entfernt aufgestellten weiteren Meßsystems und durch Bildung der Kohärenzfunktion der Teilsignale zu erreichen.

Die in Figur 1 angedeutete Einrichtung zur Modulation des Meßsignals betrifft periodisch auf die Detektionsschleife des supraleitenden Flußtransformators einwirkende Abschirmmaßnahmen. Ebensogut läßt sich auch mit anderen Teilen des Flußtransformators eine solche Modulation erreichen. Ein entsprechender, weiterer Lösungsweg wird nachfolgend anhand der Figuren 2 bis 6 aufgezeigt.

## Lösungsweg II

Wie aus dem Schaltungsschema der Figur 2 hervorgeht, ist auch eine Modulation der Gegeninduktivität M zwischen einem supraleitenden Flußtransformator 19 und einem ihm zugeordneten SQUID 20 möglich. Hierzu wird, anders als bei Gravitationswellendetektoren (vgl. z.B. "IEEE Transations on Magnetics", Vol. MAG-19, No. 3, Mai 1983, Seiten 461 bis 468), bei denen sich die Gegeninduktivität mit einer bewegten Testmasse verändert, der Strom in dem Flußtransformator vor Beginn der Messung auf null gebracht. Dann führen nämlich lediglich die kleinen Änderungen des zu messenden Feldes zu Strömen in dem Flußtransformator, deren Wirkung auf das SQUID in der gewünschten Weise moduliert wird.

Um für die Schaltung nach Figur 2 die Effektivität des Flußtransformators 19, den sogenannten "Flußtransfer", möglichst groß zu halten, kann vorteilhaft entsprechend dem in Figur 3 schematisch als Schrägansicht angedeuteten Ausführungsbeispiel von einem an sich bekannten Gleichstrom-SQUID 20 ausgegangen werden. Dieses SQUID ist zusammen mit den ihm zugeordneten Teilen des Flußtransformators 19 in Dünnfilmtechnik erstellt (vgl. "IEEE Transactions on Magnetics", Vol. MAG-17, No. I, Januar 1981, Seiten 400 bis 403). Das SQUID 20 weist eine breite SQUID-Schleife 21 mit ringähnlicher Form aus supraleitendem Material auf, die auf einer Seite durch einen schmalen Spalt bzw. Schlitz 22 unterbrochen ist und dort in zwei nach außen führende, schmale Leiterbahnen 23 und 24 mündet. Zur Optimierung der Flußeinkopplung in das SQUID, d.h. zur Minimierung der Verluste im Spalt 22, wird vorteilhaft der Spalt durch eine besondere Abdeckung oder durch Überlappung der beiden Leiterbahnen verschlossen. In dem nach außen führenden Bereich dieser Leiterbahnen sind die für ein Gleichstrom-SQUID charakteristischen beiden Josephson-Tunnelelemente 25 und 26 ausgebildet. Auf der SQUID-Schleife 21 befinden sich die Windungen der flachen Koppelspule 28 des Flußtransformators 19.

Diese ringförmige Schleife 21 umschließt ein kleines, beispielsweise quadratisches Koppelloch 30 mit einer Seitenausdehnung a von z.B. etwa 50 $\mu$m. Gemäß einer Weiterbildung der Erfindung kann nun die effektive Größe dieses Koppellochs und damit die Gegeninduktivität M der Koppelspule moduliert werden. Hierzu ist eine supraleitende ringähnliche Schleife 31 vorgesehen, die nur wenige $\mu$m von der Dünnfilmstruktur des SQUIDs 20 bzw. dessen SQUID-Schleife 21 entfernt ist. Wie in der Figur durch einen Doppelpfeil 32 angedeutet sein soll, verschließt diese ringähnliche Schleife 31 das Koppelloch 30 mit der vorbestimmten Modulationsfrequenz mehr oder weniger. Hierzu kann z.B. die ringähnliche Schleife 31 auf einer Silizium-Membran angeordnet sein, die beispielsweise piezoelektrisch, akustisch oder mechanisch bewegt wird. Die Modulationsfrequenz liegt dabei über 1 Hz, vorzugsweise über 100 Hz, z.B. über 1 kHz. Die ringähnliche Schleife 31 sollte vorteilhaft aus einem supraleitenden Material bestehen, dessen kritische Temperatur nur knapp über der Temperatur des kühlenden Bades eines entsprechenden kryogenen Mediums liegt. Außerdem ist ein Nullen des Stromes in der Schleife vor Beginn der Messung wichtig. Dies kann beispielsweise durch Heizung über Lichtleiter vorgenommen werden.

Bei dem anhand der Figuren 2 und 3 beschriebenen Weg zur Modulation des Meßsignals kann das SQUID-Signal nicht mit einem an sich bekannten Trägerfrequenzverfahren, dessen Frequenzen im Bereich von etwa 100 kHz liegen, gewonnen werden. Die Modulation durch Veränderung der effektiven Koppellochgröße würde nämlich auch die Trägerfrequenz-Modulationsamplitude mit verändern. Eine in diesem Falle vorteilhaft verwendbare Schaltung, bei der das SQUID als Niederfrequenz-Flußverstärker ohne Modulation betrieben wird, geht aus der Schaltungsskizze der Figur 4 hervor. Hierbei wird von einer Schaltung ausgegangen, wie sie mit der Veröffentlichung "SQUID 80", 1980, Seiten 227 bis 235 angeregt wird.

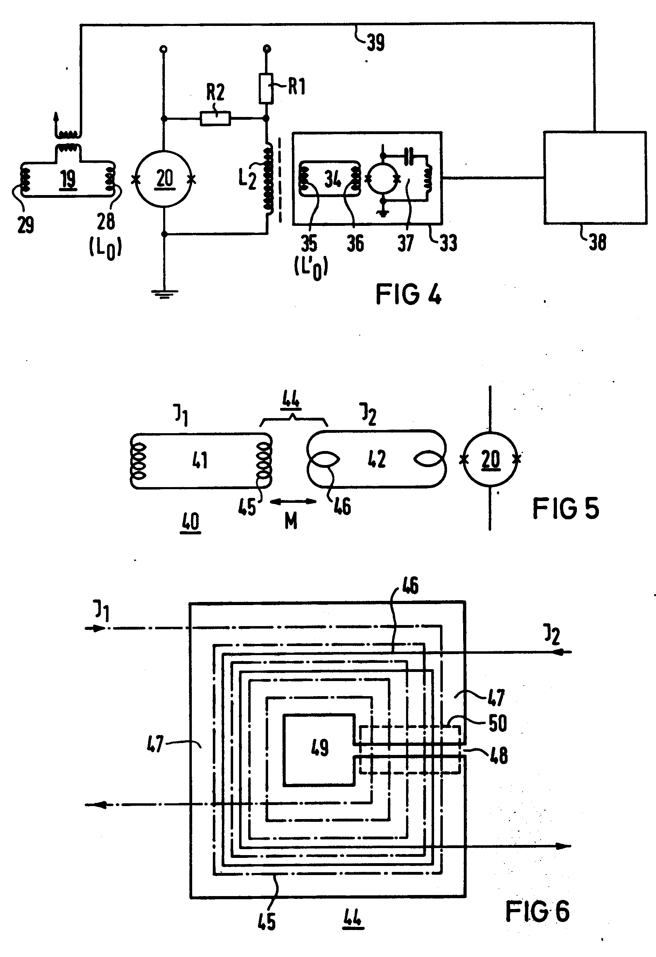

Nach Figur 4 wird das Meßsignal über einen Flußtransformator 19 mit Detektionsschleife 29 und Koppelspule 28 dem SQUID 20 zugeführt. Dem SQUID ist eine Lastimpedanz zugeordnet, die einen ohmschen Widerstand $R_2$ aufweist, welcher etwa gleich dem dynamischen Widerstand $R_s$ des SQUIDs 20 ist und in Reihe mit einer Induktivität $L_2$ liegt. Über diese Induktivität ist das Meßsignal induktiv in einen supraleitenden, auslesenden Flußsensor 33 einzukoppeln, der beispielsweise auch einen Flußtransformator 34 mit Eingangsspule 35 und Koppelspule 36 sowie ein Gleichstrom-SQUID 37 enthält. Dem Flußsensor ist eine Elektronik 38 auf Raumtemperatur nachgeschaltet.

Für das Verhältnis $R_2/L_2$ (Hz) wird der mit dem Meßproblem verträgliche kleinste Werte, d.h. die obere Grenzfrequenz $\nu_g$ von z.B. 1 kHz gewählt. Über einen Widerstand $R_1$ wird der Induktivität $L_2$ ein Vorstrom aufgeprägt, der für das auszulesende Nullinstrument die Flußreferenz vorgibt. Der maximale am SQUID vorbei in der Induktivität $L_2$ umgesteuerte Strom ist etwa gleich dem kritischen Strom $I_c$ des supraleitenden Materials. Bei verlustloser induktiver Kopplung des Flusses in der Koppelspule 28 mit einer Eingangsinduktivität $L_0$ von $L_0$ zum SQUID mit Induktivität $L_s$ und wieder verlustloser Kopplung des Flusses von $L_2$ in eine der Eingangsinduktivität $L_0$ etwa gleiche Induktivität $L_0'$ der Eingangsspule 35 des nachgeschalteten Flußsensors 33 ist dann die Flußverstärkung FV von $L_0$ nach $L_0'$ etwa gleich dem Verhältnis $\sqrt{L_2/L_s}$. Für konkrete Werte von $R_2 = 10\ \Omega$ , $\nu_g = 1$ kHz, $L_2 = 10^{-2}$ H , $L_s = 10^{-10}$ H ergibt sich dann eine Flußverstärkung von $10^4$. Selbst bei realistischen Verlusten von insgesamt zwei Größenordnungen bleibt noch eine Flußverstärkung in einer Stufe von einanderreihbaren SQUID-Verstärkern von etwa $10^2$ erhalten. Eine solche Flußverstärkung reicht in jedem Falle aus, um einen konventionellen Flußmesser wie z.B. einen Flußgate-Sensor an- bzw. auszusteuern. Es kann aber z.B. auch ein SQUID als Ausleseverstärker benutzt werden. In letzteren Fall ist die Induktivität $L^2$ in der Größenordnung von etwa $10^{-2}$ H vorteilhaft eine aus dünnem Nb-Draht gewickelte Spule, die auf einem Folienwickel aufliegt, dessen Induktivität an die Induktivität der Auslesesquid-Koppelspule 36 von etwa 0,3 $\mu$H angepaßt ist.

Das Auslesesquid 37 kann konventionell, also mit Modulation, betrieben werden, da es viel weiter ausgesteuert wird als das Primärsquid 20. Durch eine Gegenkopplung, die vorteilhaft einen Integrierer enthält und insbesondere auf den Flußtransformator 19 des Primärsquids 20 einwirkt, wird die Gesamtschaltung linearisiert. Eine solche Flußgegenkopplung von der Elektronik 38 auf den Flußtransformator 19 ist in der Figur mit 39 bezeichnet.

Mit der in Figur 4 gezeigten Schaltung ergibt sich insbesondere der Vorteil, daß durch die Flußreferenz in $L_2$ genau der Arbeitspunkt größter Transferfunktion und kleinsten Eigenrauschens des Primärsquids 20 stabilisiert werden kann. Dabei treibt keine Modulation das Primärsquid aus diesem Zustand heraus, so lange die Gegenkopplung 39 wirksam ist. Die durch einen Gleichstrom vorgegebene Flußreferenz unterliegt dabei nicht irgendwelchen unerwünschten Thermospannungsdriften. Solche Driften treten auch nicht beim Vorgang des Fluß-bzw. Stromauslesens durch ein Ausleseinstrument auf. Durch die Wahl einer Verstärkerkaskade bei tiefer Temperatur in Gestalt des Primärsquids 20 und des Ausleseinstrumentes in Form des Sensors 33 kann die Raumtemperatur-Elektronik 38 verhältnismäßig einfach gehalten werden.

Abweichend von der anhand den Figuren 2 bis 4 angedeuteten Modulation der Gegeninduktivität bezüglich des SQUIDs besteht auch die Möglichkeit, den Flußtransformator in bekannter Weise in zwei Stufen aufzuteilen (vgl. z.B. "IEEE Transactions on Magnetics", Vol. MAG-19, No. 3, 1983, Seiten 303 bis 307). Ein entsprechendes Schaltungsschema geht aus Figur 5 hervor. Der mit 40 bezeichnete Flußtransformator enthält dementsprechend zwei schleifenartige, elektrisch in sich geschlossene Stufen 41 und 42, die jeweils quasi einzelne kleinere Flußtransformatoren darstellen und in denen Ströme $J_1$ bzw. $J_2$ fließen. Die Kopplung zwischen diesen Stufen mit einer Gegeninduktivität M erfolgt über einen in an sich bekannter Weise aufgebauten Flachspultransformator 44 (vgl. z.B. US-PS 3 184 674). Die den Stufen 41 und 42 zuzuordnenden Transformatorspulen sind mit 45 bzw. 46 bezeichnet.

Dieser Transformator 44 ist in Figur 6 schematisch als Aufsicht näher ausgeführt. Er enthält zwei integrierte Dünnfilmspulen 45 und 46, die durch eine strichpunktierte bzw. durchgezogene Linie veranschaulicht sind. Diese Spulen sind gemeinsam und übereinanderliegend auf einer geschlitzten ringähnliche geformten Fläche 47 mit überlappendem bzw. abgedecktem Schlitz 48 und Koppelloch 49 aufgebracht. Die mit 50 bezeichnete Schlitzabdeckung ist durch eine gestrichelte Linie angedeutet. Somit entspricht dieser Transformator 44 weitgehend dem in Figur 3 gezeigten Transformator 20, wenn davon abgesehen wird, daß die Fläche 47 keine Josephson-Elemente aufweist. Wie bei der Ausführungsform nach Figur 3 wird auch hier eine Modulation der effektiven Größe des Koppelloches mit einer supraleitenden ringähnlichen Schleife vorgenommen. Vor Beginn der Messung werden die beiden Ströme $J_1$ und $J_2$ in den Dünnfilmspulen 45 bzw. 46 in der beschriebenen Weise genullt. Bei der anhand der Figuren 5 und 6 angedeuteten Modulationsmöglichkeit läßt sich das übliche Trägerfrequenzverfahren zum Auslesen des SQUID-Signals verwenden.

Auch für den Lösungsweg II können sinngemäß die im Zusammenhang mit dem Lösungsweg I aufgeführten Maßnahmen bezüglich einer Störfeldunterdrückung durch Hilfsfelder und Verwendung einer entfernten Referenz vorgesehen werden.

**Patentansprüche**

1. Vorrichtung zur Messung von schwachen magnetischen Feldern extrem geringer Frequenz, die unter 1 Hz liegen kann, mittels eines SQUID-Magnetometers, wobei das SQUID-Magnetometer

   a) einen supraleitenden Schaltungsteil aufweist, der
   - ein SQUID (2, 20) mit einer SQUID-Schleife (21) enthält
   und
   - einen dem SQUID (2, 20) vorgeordneten, einen magnetischen Fluß führenden Flußtransformator (5, 19, 40) umfaßt, der
   $\alpha$) eine Detektionsschleife (9, 29) zum Empfang der magnetischen Felder und
   $\beta$) eine Koppelspule (6, 28) zur induktiven Einkopplung der an der Detektionsschleife (9, 29) gewonnenen Meßsignale in die SQUID-Schleife (21) enthält,

   sowie

   b) mit einer Einrichtung mit einem beweglichen Teil zur Modulation der in das SQUID (2, 20) einzukoppelnden Meßsignale mit einer Modulationsfrequenz, die in einem für einen rauscharmen Betrieb des SQUIDs (2, 20) charakteristischen Frequenzbereich liegt, versehen ist,
   **dadurch gekennzeichnet, daß**
   - das SQUID (2, 20) als ein Gleichstrom-SQUID ausgebildet ist,
   - die Modulationeinrichtung nur einem Teilbereich des Schaltungsteils zugeordnet ist, wobei dieser Teilbereich
   $\alpha$) die Detektionsschleife (9)
   oder
   $\beta$) ein aus der Koppelspule (28) und der SQUID-Schleife (21) gebildetes induktives Koppelglied
   oder
   $\gamma$) ein Koppeltransformator (44), der zwei Transformatorstufen (41, 42) des Flußtransformators (40) induktiv koppelt,
   ist,
   und daß
   - der bewegliche Teil der Modulationseinrichtung als ein diskretes, schleifenförmiges, supraleitendes Element (12, 31) ausgebildet ist, welches aufgrund einer periodisch mit der vorbestimmten Modulationsfrequenz erfolgenden Bewegung auf den Teilbereich einwirkt.

2. Vorrichtung nach Anspruch 1, **dadurch gekennzeichnet,** daß das diskrete Element der Modulationseinrichtung, welches der Detektionsschleife (9) zugeordnet ist, ein Abschirmring (12) ist, der um eine Achse (A) drehbar gelagert ist, die sich quer durch den Abschirmring (12) erstreckt und parallel zur Ebene der Detektionsschleife (9) liegt.

3. Vorrichtung nach Anspruch 2, **dadurch gekennzeichnet,** daß supraleitende Lager (14) mit supraleitender Abschirmung (15) zur magnetischen Lagerung des rotierenden Abschirmringes (12) vorgesehen sind.

4. Vorrichtung nach Anspruch 2 oder 3, **dadurch gekennzeichnet,** daß der rotierende Abschirmring (12) in superfluidem Helium angeordnet ist.

5. Vorrichtung nach Anspruch 1, **dadurch gekennzeichnet,** daß das diskrete Element der Modulationseinrichtung , welches dem induktiven Koppelglied zugeordnet ist, eine ringähnliche Schleife (31) ist, daß die SQUID-Schleife (21) ringförmig und geschlitzt gestaltet ist, daß auf der SQUID-Schleife (21) die Windungen der Koppelspule (28) des Flußtransformators (19) angeordnet sind und daß die SQUID-Schleife (21) ein Koppelloch (30) umschließt, dessen effektive Größe mittels der ringähnlichen Schleife (31) zur Modulation der Gegeninduktivität (M) zwischen dem Flußtransformator (19) und dem SQUID (20) zu beeinflussen ist.

6. Vorrichtung nach Anspruch 5, **dadurch gekennzeichnet,** daß dem SQUID (20) ein ohne Modulation zu betreibender Flußverstärker mit einem Flußsensor (33) und einer Ausleseelektronik (38) nachgeschaltet ist.

7. Vorrichtung nach Anspruch 6, **dadurch ge-**

**kennzeichnet,** daß an das SQUID (20) ein Lastkreis angeschlossen ist, dessen ohmscher Lastwiderstand ($R_2$) in Reihe mit einer Induktivität ($L_2$) liegt, über die das Signal in den Flußsensor (33) induktiv einzukoppeln ist.

8. Vorrichtung nach Anspruch 6 oder 7, **dadurch gekennzeichnet,** daß der Flußsensor (33) ein Gleichstrom-SQUID (37) zum Auslesen aufweist.

9. Vorrichtung nach Anspruch 1, **dadurch gekennzeichnet,** daß das diskrete Element der Modulationseinrichtung, welches dem induktiven Koppeltransformator (44) zugeordnet ist, eine ringähnliche Schleife (31) ist und daß die zwei Transformatorstufen (41, 42) über zwei Spulen (45, 46) des Koppeltransformators (44) induktiv gekoppelt sind, die ein gemeinsames Koppelloch (49) umschließen, dessen effektive Größe mittels der ringähnlichen Schleife (31) zur Modulation der Gegeninduktivität (M) der zwei Spulen (45, 46) zu beeinflussen ist.

10. Vorrichtung nach einem der Ansprüche 1 bis 9, **dadurch gekennzeichet,** daß das SQUID (2, 20) und die Koppelspule (6, 28) des ihm zugeordneten Flußtransformators (5, 19, 40) zu einer baulichen Einheit in Dünnfilmtechnik integriert sind.

11. Vorrichtung nach Anspruch 10, **dadurch gekennzeichnet,** daß das SQUID (2, 20) und die zugeordnete Koppelspule (6, 28) von einer supraleitenden Abschirmung (7) umgeben sind.

12. Vorrichtung nach einem der Ansprüche 1 bis 11, **dadurch gekennzeichnet,** daß eine Modulationsfrequenz von über 1 Hz, vorzugsweise von über 100 Hz vorgesehen ist.

**Claims**

1. Device for measuring weak magnetic fields of extremely low frequency, which may be below 1 Hz, by means of a SQUID magnetometer, whereby the SQUID magnetometer
   a) has a superconducting circuit part which
      - contains a SQUID (2, 20) having a SQUID loop (21)
   and
      - comprises a flux transformer (5, 19, 40) arranged in front of the SQUID (2, 20) and conducting a magnetic flux, this transformer containing
         α) a detection loop (9, 29) for receiving the magnetic fields and
         β) a coupling coil (6, 28) for the inductive coupling into the SQUID loop (21) of the measuring signals obtained on the detection loop (9, 29),
   and
   b) is provided with a device with a movable part for the modulation of the measuring signals to be coupled into the SQUID (2, 20) with a modulation frequency lying in a frequency range characteristic for low noise operation of the SQUID (2, 20),
characterised in that
   - the SQUID (2, 20) is formed as a d-c SQUID
   - the modulation device is associated with only a partial region of the circuit part, this partial region being
      α) the detection loop (9)
      or
      β) an inductive coupling member formed from the coupling coil (28) and the SQUID loop (21)
      or
      γ) a coupling transformer (44) which inductively couples two transformer steps (41, 42) of the flux transformer (40),
and in that
   - the movable part of the modulation device is formed as a discrete, loop-shaped, superconducting element (12, 31) which acts on the partial region because of a movement occurring periodically with the predetermined modulation frequency.

2. Device according to claim 1, characterised in that the discrete element of the modulation device, which is associated with the detection loop (9), is a shielding ring (12) which is rotatably mounted about an axis (A) which extends transversely through the shielding ring (12) and lies parallel to the plane of the detection loop (9).

3. Device according to claim 2, characterised in that superconducting bearings (14) are provided with superconducting shielding (15) for the magnetic bearing of the rotating shielding ring (12).

4. Device according to claim 2 or 3, characterised in that the rotating shielding ring (12) is disposed in superfluid helium.

5. Device according to claim 1, characterised in that the discrete element of the modulation device, which is associated with the inductive coupling member, is a ring-like loop (31), in that the SQUID loop (21) is of annular shape and slotted, in that the turns of the coupling coil (28) of the flux transformer (19) are arranged on the SQUID loop (21) and in that the SQUID loop (21) surrounds a coupling hole (30) whose effective size can be influenced by means of the ring-like loop (31) for modulating the mutual inductance (M) between the flux transformer (19) and the SQUID (20).

6. Device according to claim 5, characterised in that subsequently connected to the SQUID (20) is a flux amplifier which is to be operated without modulation and which has a flux sensor (33) and an electronic read-out means (38).

7. Device according to claim 6, characterised in that a load circuit is connected to the SQUID (20) and its ohmic load resistance ($R_2$) is in series with an inductance ($L_2$) by means of which the signal is to be inductively coupled into the flux sensor (33).

8. Device according to claim 6 or 7, characterised in that the flux sensor (33) has a d-c SQUID (37) for reading-out.

9. Device according to claim 1, characterised in that the discrete element of the modulation device, which is associated with the inductive coupling transformer (44), is a ring-like loop (31), and in that the two transformer steps (41, 42) are inductively coupled by means of two coils (45, 46) of the coupling transformer (44) which surround a common coupling hole (49) whose effective size can be influenced by means of the ring-like loop (31) for modulating the mutual inductance (M) of the two coils (45, 46).

10. Device according to one of claims 1 to 9, characterised in that the SQUID (2, 20) and the coupling coil (6, 28) of the flux transformer (5, 19, 40) associated with it are integrated to form a structural unit in thin film technology.

11. Device according to claim 10, characterised in that the SQUID (2, 20) and the associated coupling coil (6, 28) are surrounded by a superconducting shield (7).

12. Device according to one of claims 1 to 11, characterised in that a modulation frequency above 1 Hz, preferably above 100 Hz, is provided.

**Revendications**

1. Dispositif pour la mesure de champs magnétiques faibles et de fréquence extrêmement faible, pouvant se situer en-dessous de 1 Hz, à l'aide d'un magnétomètre à SQUID, le magnétomètre à SQUID comportant

a) une partie de circuit à supraconduction, qui comporte

- un SQUID (2, 20) avec une boucle de SQUID (21)

et

- comporte, en amont du SQUID (2, 20), un transformateur de flux magnétique (5, 19, 40) traversé par le flux et qui comprend

α) une boucle de détection (9, 29) pour recevoir les champs magnétiques

et

β) une bobine de bouclage (6, 28) pour introduire inductivement dans la boucle de SQUID (21), les signaux de mesure obtenus au niveau de la boucle de détection (9, 29)

et étant pourvu

b) d'un dispositif à partie mobile pour la modulation des signaux de mesure à introduire dans le SQUID (2, 20) avec une fréquence de modulation qui se situe dans une gamme de fréquences qui est caractéristique pour un fonctionnement à faible bruit du SQUID (2, 20),

caractérisé par le fait que

- le SQUID (2, 20) est réalisé sous la forme d'un SQUID en courant continu,
- le dispositif de modulation n'est associé qu'à une zone partielle de la partie de circuit, cette zone partielle étant constituée par

α) la boucle de détection (9)

ou

β) un élément de couplage inductif formé par la bobine de couplage (28) et par la boucle de SQUID (21)

ou

γ) un transformateur de couplage (44) qui couple inductivement deux étages (41, 42) du transformateur du flux

et que

- la partie mobile du dispositif de modulation est réalisée sous la forme d'un élément à supraconduction (12, 31), discret et en forme de boucle, et qui agit sur la zone partielle, par suite d'un mouvement périodique effectué à une fréquence de modulation prédéterminée.

2. Dispositif selon la revendication 1, caractérisé par le fait que l'élément discret du dispositif de modulation qui est associé à la boucle de détection (9), est un anneau-écran (12) qui est monté de façon à pouvoir tourner autour d'un axe (A) qui s'étend transversalement à travers l'anneau-écran (12) et qui se situe parallèlement au plan de la boucle de détection (9).

3. Dispositif selon la revendication 2, caractérisé par le fait que des paliers à supraconduction (14), avec un écran à supraconduction (15), sont prévus pour le montage magnétique de l'anneau-écran tournant (12).

4. Dispositif selon la revendication 2 ou 3, caractérisé par le fait que l'anneau-écran tournant (12) est disposé dans de l'hélium suprafluide.

5. Dispositif selon la revendication 1, caractérisé par le fait que l'élément discret du dispositif de modulation, qui est associé à l'élément de couplage inductif, est constitué par une boucle (31) d'allure similaire à un anneau, que la boucle de SQUID (21) a une forme annulaire et est fendue, que sur la boucle de SQUID (21) sont disposées les spires de la bobine de couplage (28) du transformateur de flux (19) et que la boucle de SQUID (21) entoure une ouverture de couplage (30) dont la grandeur effective est susceptible d'être influencée, à l'aide de la boucle (31) analogue à un anneau, pour la modulation de l'inductance mutuelle (M) entre le transformateur de flux (19) et le SQUID (20).

6. Dispositif selon la revendication 5, caractérisé par le fait qu'en aval du SQUID (20) est monté un amplificateur de flux, opérable sans modulation, avec un capteur ou détecteur de flux (33) et une électronique de lecture (38).

7. Dispositif selon la revendication 6, caractérisé par le fait qu'au SQUID (20) est relié un circuit de charge dont la résistance ohmique de charge ($R_2$) est montée en série avec une inductance ($L_2$), par l'intermédiaire de laquelle le signal est à introduire, par voie inductive, dans le détecteur ou capteur de flux (33).

8. Dispositif selon la revendication 6 ou 7, caractérisé par le fait que le capteur ou détecteur de flux (33) comporte, pour la lecture, un SQUID en courant continu (37).

9. Dispositif selon la revendication 1, caractérisé par le fait que l'élément discret du dispositif de modulation qui est associé au transformateur de couplage inductif (44) est constitué par une boucle (31) de forme similaire à un anneau, et que les deux étages (41, 42) du transformateur sont couplés inductivement par l'intermédiaire de deux bobines (45, 46) du transformateur de couplage (44), lesquelles bobines entourent une ouverture de couplage commune (49) dont la dimension effective est à influencer à l'aide de la boucle (31), similaire à un anneau, pour la modulation de l'inductance mutuelle (M) des deux bobines (45, 46).

10. Dispositif selon l'une des revendications 1 à 9, caractérisé par le fait que le SQUID (2, 20) et la bobine de couplage (6, 28) du transformateur de flux (5, 19, 40) qui lui est associée, sont intégrés pour constituer une unité de construction en technique à couche mince.

11. Dispositif selon la revendication 10, caractérisé par le fait que le SQUID (2, 20) et la bobine de couplage associée (6, 28) sont entourés par un écran à supraconduction (7).

12. Dispositif selon l'une des revendications 1 à 11, caractérisé par le fait qu'il est prévu une fréquence de modulation supérieure à 1 Hz, de préférence supérieure à 100 Hz.

FIG 1

FIG 2

FIG 3

FIG 4

FIG 5

FIG 6